# EUROPÄISCHE PATENTSCHRIFT

(11) **EP 1 891 846 B1**
(45) Veröffentlichungstag und Bekanntmachung des Hinweises auf die Patenterteilung: **18.03.2009**
(21) Anmeldenummer: 06741644.6
(22) Anmeldetag: 14.06.2006
(51) Int. Cl.: H05K 7/20, H02B 1/56

(54) **ELEKTROSCHRANK**
ELECTRICAL CONTROL CABINET
ARMOIRE ELECTRIQUE

(30) Priorität: 15.06.2005 CH 10182005; 26.07.2005 CH 12412005
(43) Veröffentlichungstag der Anmeldung: 27.02.2008
(73) Patentinhaber: Almatec AG, 6170 Schüpfheim (CH); Hertli, Alfred, 6072 Sachseln (CH)
(72) Erfinder: Hertil, Alfred, 6072 Sachsein (CH)
(74) Vertreter: Lauer, Joachim
(86) Internationale Anmeldenummer: PCT/CH2006/000319
(87) Internationale Veröffentlichungsnummer: WO 2006/133589

(56) Entgegenhaltungen:
- EP-A- 1 330 150
- EP-A- 1 367 878
- EP-B- 1 002 352
- PATENT ABSTRACTS OF JAPAN Bd. 2000, Nr. 23, 10. Februar 2001 (2001-02-10) & JP 2001 168565 A (SANKEN ELECTRIC CO LTD), 22. Juni 2001 (2001-06-22)
- PATENT ABSTRACTS OF JAPAN Bd. 1999, Nr. 09, 30. Juli 1999 (1999-07-30) & JP 11 112179 A (DX ANTENNA CO LTD), 23. April 1999 (1999-04-23)
- PATENT ABSTRACTS OF JAPAN Bd. 2003, Nr. 02, 5. Februar 2003 (2003-02-05) & JP 2002 303445 A (SAKAMAKI TADASHI), 18. Oktober 2002 (2002-10-18)
- PATENT ABSTRACTS OF JAPAN Bd. 2003, Nr. 12, 5. Dezember 2003 (2003-12-05) & JP 2004 212760 A (CANON INC), 29. Juli 2004 (2004-07-29)
- PATENT ABSTRACTS OF JAPAN Bd. 2000, Nr. 03, 30. März 2000 (2000-03-30) & JP 11 354962 A (FUJITSU I NETWORK SYSTEMS LTD), 24. Dezember 1999 (1999-12-24)

## Beschreibung

### TECHNISCHES GEBIET

Die vorliegende Erfindung betrifft einen Elektroschrank für Verlustwärme erzeugende Komponenten mit einem Schraukkörper und einem austauschgaren Dach.

### STAND DER TECHNIK

Elektroschränke der genannten Art werden unter anderem in der Telekommunikation oder in der Netzwerktechnik eingesetzt, wo es auf hohe Zuverlässigkeit der in ihnen eingebauten Komponenten ankommt. Ein wesentliches Problem besteht darin, die durch die Verlustwärme der eingebauten Komponenten erhöhte Temperatur im Innenraum unterhalb eines definierten Wertes zu halten und eine Überhitzung der Komponenten zu verhindern. Hierzu werden Entwärmungsmittel eingesetzt. Sofern die Elektroschränke im Freien aufgestellt sind, was vor allem in der Telekommunikation die Regel ist, sind sie zudem den Witterungseinflüssen einschliesslich ggf. intensiver Sonnenbestrahlung ausgesetzt, was dann zusätzliche Anforderungen an ihre Entwärmung stellt.

Im Stand der Technik sind verschiedenste Entwärmungskonzepte bekannt, die doppelschalige Wandstrukturen, den Einsatz von Ventilatoren, von Wärmetauschern und/oder von Kühlaggregaten umfassen. Sie unterscheiden sich wesentlich hinsichtlich Ihrer Entwärmungsleistung und werden entsprechend des zu erwartenden Wämeanfalls ausgewählt. Man unterscheidet dabei auch zwischen geschlossenen und offenen Systemen, wobei bei den geschlossenen Systemen der Innenraum zum Schutz der Komponenten gegen Luftverunreinigungen hermetisch abgeschlossen ist. Bei den offenen Systemen wird Umgebungsluft durch den Innenraum geblasen, was entwärmungstechnisch effektiver ist, in der Regel aber den Einsatz von Filtern zur Reduktion der Staubbelastung erfordert. Als Beispiel für ein geschlossenes System mit Wärmetauscherfunktion kann das Patent EP 1002352 B1 der vorliegenden Anmelderin genannt werden.

Elektroschränke der betrachteten Art können nicht nach Belieben einfach aufgestellt werden, Ihre Standortwahl unterliegt vielfachen Anforderungen und Einschränkungen unter anderem architektonischer oder auch städtebaulicher Art. Die für die Aufstellung benötigte Fläche wird in der Regel bereits bei der Planung von Wohngebieten, Strassen oder Gebäuden ausgewiesen und muss durch die aufstellende Gesellschaft häufig sogar im Eigentum erworben oder zumindest angemietet werden. Sofern die Elektroschränke mit Aggregaten wie Ventilatoren ausgerüstet sind, die unvermeidlich Lärm erzeugen, müssen auch die jeweils geltenden Lärmschutzbestimmungen beachtet werden. Einmal gefundene und akzeptierte Standorte werden daher meist langfristig beibehalten und ohne Not nicht mehr verändert.

Aus den genannten Gründen ist es auch üblich, Elektroschränke bei ihrer Aufstellung so zu dimensionieren, dass sie über den aktuellen Bedarf hinaus über eine gewisse Ausbaukapazität verfügen. Dennoch kommt es immer wieder vor, dass vorhandene Elektroschränke neuen Anforderungen nicht mehr entsprechen, wenn z.B. ein neues Wohngebiet oder ein grösseres Gebäude mit einer Vielzahl neuer Teilnehmer an das Telekommunikationsnetz anzuschliessen ist. Das hierbei auftretende Problem ist vor allem ein Wärmeproblem. Es ist meist die Entwärmungsleistung des Elektroschranks, die sich als nicht mehr ausreichend erweist.

Bei den bekannten Elektroschränken ist die Entwärmungsleistung im Rahmen ihrer Bauweise im wesentlichen ausgereizt und kann nicht einfach erhöht werden. Im Falle erhöhten Bedarfs muss von daher meist der Elektroschrank als Ganzes gegen einen solchen von anderer Bauweise ausgetauscht werden. Die Aufstellung eines weiteren Elektroschranks neben den bereits vorhandenen ist wegen der erläuterten Platzproblematik nur in Ausnahmefällen möglich. Der Anbau zusätzlicher Entwärmungsaggregate an einen vorhandenen Elektroschrank verbietet sich ebenfalls in vielen Fällen durch den beschränkten Platz. Sofern bereits mehrere Elektroschränke aneinandergebaut sind, ist ein seitlicher Anbau weiterer Aggregate zusätzlich erschwert. Jedenfalls kann ein seitlicher Anbau nur situativ. d.h. unter Berücksichtigung der jeweiligen örtlichen Verhältnisse vorgenommen werden. Ausserdem erzeugen zusätzliche Elektroschränke oder zusätzliche Aggregate in der Regel auch zusätzlichen Lärm und wären bereits von daher wegen der Lärmbegrenzungsvorschriften an vielen Standorten nicht zulässig.

### DARSTELLUNG DER ERFINDUNG

Die Erfindung liegt die Aufgabe zugrunde, bezüglich der erläuterten Probleme Abhilfe zu schaffen und anzugeben, wie den unterschiedlichen und insbesondere steigenden Anforderungen an die Kühlleistung bei Elektroschränken der eingangs genannten Art in einfacher und flexibler Weise Rechnung getragen werden kann.

Diese Aufgabe wird erfindungsgemäss gelöst durch die in den Patentansprüchen 1 oder 5 gekennzeichneten Merkmale.

Die vorliegende Erfindung sieht in ihrem Kern gemäss den Ansprüchen 1 oder 5 daher vor, dass das Dach mit lösbaren Anschlüssen versehen und gegen ein mit entsprechenden Anschlüssen versehenes Austauschdach austauschbar ist.

Infolge dieser Massnahmen wird ein Elektroschrank im Rahmen eines modularen Konzeptes geschaffen, der mit mindestens einem, gegenüber dem jeweils vorhandenen Dach ggf. unterschiedlich ausgebildeten Austauschdach in einfacher Weise ausgestattet werden kann. In dem Austauschdach können Entwärmungsmittel bzw. -aggregate verschiedenster Ausbildung und damit Entwärmungsleistung vorgesehen sein. Die für verschiedene Entwärmungsmittel bzw. -aggregate ggf. erforderliche unterschiedliche Bauhöhe des Austauschdaches steht nach oben hin praktisch immer zu Verfügung im Unterschied zu den meist begrenzten Platzverhältnissen zur Seite hin.

Über den sich nach unten annähernd über die Höhe des Elektroschranks erstreckenden Kühlluftkanal kann Kühlluft von im Austauschdach angeordneten Entwärmungsmitteln direkt in den unteren Bereich des Elektroschranks eingeleitet werden, wo sie benötigt wird, und zwar unabhängig davon, auf welche Weise sie im Austauschdach erzeugt wird.

Bei der erfindungsgemässen Ausbildung werden der Elektroschrank und das ihn nach oben abschliessende Dach z.B. durch eine gewisse Verbreiterung gegenüber den Ausbildungen nach dem Stand der Technik so dimensioniert, dass das Dach gegen ein Austauschdach mit Kühlluftkanal austauschbar und im Innenraum des Elektroschranks ausreichend Platz für einen Kühlluftkanal vorhanden ist, selbst wenn ein solcher z.B. in einer ersten Ausbaustufe noch nicht benötigt wird.

Die Erfindung ermöglicht es der den Elektroschrank aufstellenden Gesellschaft, diesen je nach den aktuellen Anforderungen an die Entwärmungsleistung mit den jeweils geeigneten Entwärmungsmittieln zu versehen. Insbesondere ist es nicht erforderlich, die Entwärmungsmittel von Anfang an lediglich im Hinblick auf einen allfälligen späteren Bedarf vorzusehen und/oder wesentlich leistungsfähiger als unmittelbar erforderlich zu dimensionieren. Erst wenn der Bedarf entsteht, kann das vorhandene Dach, in dem natürlich ebenfalls bereits gewisse Entwärmungsmittel vorhanden sein können und das ebenfalls auch schon einen Kühlluftkanal aufweisen kann, durch ein Austauschdach mit leistungsfähigeren Entwärmungsmitteln ersetzt werden. Dabei sind irgendwelche weiteren Veränderungen bzw. Anpassungen an dem erfindungsgemässen Elektroschrank nicht erforderlich. Insbesondere ist der für den Kühlkanal erforderliche Platz im Elektroschrank von vornherein bereits vorgesehen.

Selbstverständlich wäre es auch möglich, den Elektroschrank durch Austausch des Daches "nach unten" zu dimensionieren, sofern die ursprünglich installierte Entwärmungsleistung sich als zu gross oder nicht mehr erforderlich erweisen sollte. Modernisierungen und Ersatz der Technik durch z.B. leisere und/oder weniger Energie benötigende Aggregate sind dadurch natürlich auch in einfacher, rationeller und kostengünstiger Weise möglich.

Der Kühlluftkanal oder der für seine Aufnahme reservierte Aufnahmeraum weist bei einem einfachen Schrank mit nur einer Tür bevorzugt z.B. eine Breite von 50 mm und eine im wesentlichen der Schranktiefe entsprechende Tiefe von z.B. 300 mm auf. Bei doppeltbreiten Schränken mit zwei Türflügeln kann der Kühlkanal bzw. der Aufnahmeraum in der Mitte plaziert und mit einer doppelten Breite von z.B. 100 mm bemessen sein. Zumindest an seinem unteren Ende ist der Kühlluftkanal mit einer Austrittsöffnung für Kühlluft versehen. Zusätzliche Öffnungen weiter oben könnten im Kühlluftkanal natürlich ebenfalls bei Bedarf vorgesehen sein.

Weiter bevorzugt ist der Kühlluftkanal ausschliesslich mit dem Austauschdach verbunden und wird ausschliesslich durch dieses gehalten. Zumindest sollten im Elektroschrank bei der Anbringung eines Austauschdachs keine aufwendigen Massnahmen zur Montage des Kühlluftkanals erforderlich sein.

Gemäss einer weiteren bevorzugten Ausführungsform ist bzw. sind das Dach und/oder das Austauschdach als Ganzes zusammen mit dem Kühlluftkanal handhabbar, was ebenfalls ihre Montage bzw. ihren Austausch rationell macht.

In vielen Fällen wird es nötig sein, elektrische Versorgungs- und/oder Signalleitungen vom Dach oder Austauschdach aus in den Innenraum zu führen oder umgekehrt, wenn z.B. im Innenraum ein Temperatursensor vorhanden ist und im Dach oder Austauschdach vorhandene Entwärmungsaggregate in Abhängigkeit von dessen Signal gesteuert werden sollen. Mit Vorteil wird für diese Fälle das Dach und/oder das Austauschdach gegen den Innenraum hin von vornherein mit einer Anschlussvorrichtung für solche elektrische Versorgungs- und/oder Signalleitungen versehen, die z.B. als Steckverbindung oder als freies in den Innenraum hineinreichendes Kabel ausgebildet sein kann.

### KURZE ERLÄUTERUNG DER FIGUREN

Die Erfindung soll nachfolgend anhand von Ausführungsbeispielen im Zusammenhang mit der Zeichnung näher erläutert werden. Es zeigen:
- Fig. 1: einen Elektroschrank nach der Erfindung in einem Längsschnitt (A-A in Fig. 2) mit einem Kopflüfterdach;
- Fig. 2: den Elektroschrank von Fig. 1 in einem Querschnitt (B-B in Fig. 1);
- Fig. 2a: eine Detaildarsteliung von Fig. 2
- Fig. 3: den Elektroschrank von Fig. 1 mit abgenommenem Dach;
- Fig. 4: in einer Darstellung gemäss Fig. 1 eine andere Ausführungsform eines erfindungsgemässen Elektroschranks mit einem Membranfilterdach;
- Fig. 5: den Elektroschrank von Fig. 4 mit abgenommenem Dach;
- Fig. 6: in einer Darstellung gemäss Fig. 1 noch eine weitere Ausführungsform eines erfindungsgemässen Elektroschranks mit einem Wärmetauscherdach;
- Fig. 7: den Elektroschrank von Fig. 6 mit abgenommenem Dach; und
- Fig. 8: eine schematische Darstellung des Wärmetauschers von Fig. 6.

### WEGE ZUR AUSFÜHRUNG DER ERFINDUNG

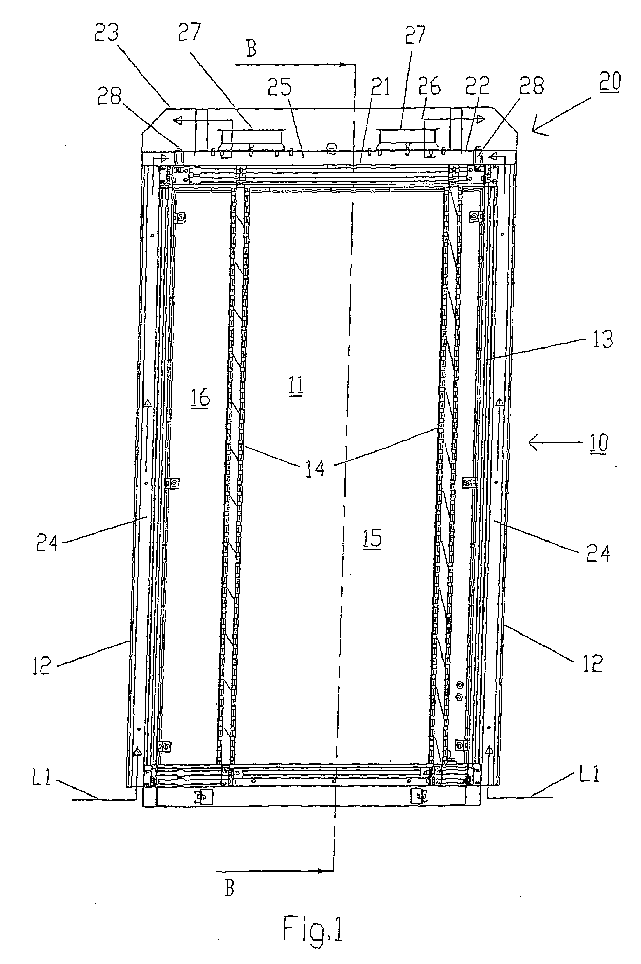

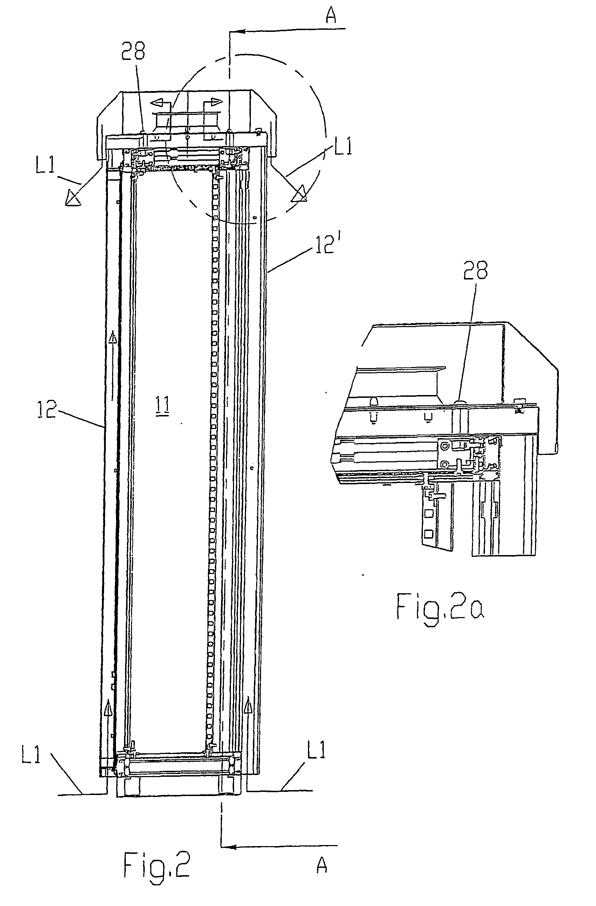

Bei dem in den Fig. 1 - 3 dargestellten Elektroschrank Handelt es sich nicht um ein Ausführungsbeispiel der Erfindung, sondern um ein Beispiel, das des Verständnis der Erfindung erleichtert. Dieser Elektroschrank weist einen Schrankkörper 10 mit einem von Seitenwänden 12 umschlossenen innenraum 11 auf. Die in Fig. 2 rechte Seitenwand 12' ist als Tür ausgebildet. Mechanisch stabilisiert wird der Schrankkörper 10 durch stangenförmige Profile 13, die auch als Träger für die Seitenwände 12 dienen. Im Innenraum 11 sind weiterhin sogenannten Racks 14 (z.B. im 19 Zoll Format) vorhanden, an und zwischen welchen unterschiedliche Komponenten wie Verlustwärme erzeugende Elektronikeinheiten oder dergleichen (nicht dargestellt) angeschraubt werden können. Der freie Raum zwischen den Racks 14 bildet daher einen Aufnahmebereich 15 für solche Komponenten. Die Racks 14 halten beidseitig etwas Abstand von den Seitenwänden 12, so dass dort ebenfalls sowie selbst bei voller Bestückung mit Komponenten ein freier Raum verbleibt. Auf der in Fig. 1 linken Seite ist dieser Abstand grösser gewählt als auf der rechten Seite, um dadurch einen Aufnahmeraum 16 für einen (hier noch nicht vorhandenen) Kühlluftkanal bereitzustellen.

Der Elektroschrank von Fig. 1 - 3 weist weiterhin ein Dach auf, welches als Kopflüfterdach ausgebildet ist. Es umfasst ein Unterdach 21, ein Zwischendach 22 und ein Oberdach 23. Das Unterdach 21 schliesst den Innenraum 11 des Schrankkörpers 10 nach oben ab, der durch die Seitenwände und einen Boden auch im übrigen hermetisch dicht abgeschlossen ist. Ein erster Zwischenraum 24 zwischen den Schalen der Seitenwände 12 ist nach unten zur Umgebung hin offen und steht mit einem zweiten Zwischenraum 25 zwischen dem Unterdach 21 und dem Zwischendach 22 in Verbindung. Ein dritter Zwischenraum 26 zwischen dem Zwischendach 22 und dem Oberdach 23 ist, wie in Fig. 2 und 2a ersichtlich, randseitig zur Umgebung hin offen, indem das Oberdach etwas tiefer als der Schrankkörper 10 ausgebildet ist und nach vorn und hinten hin unter Ausbildung jeweils eines Spaltes über diesen etwas übersteht. Im Zwischendach 22 sind noch zwei Ventilatoren 27 angeordnet.

Die Ventilatoren 27 erzeugen einen kühlen Luftstrom L1 aus der Umgebung von unten durch den ersten 24 und zweiten Zwischenraum 25 in den dritten Zwischenraum 26 und von dort durch die genannten Spalte zwischen Unter- und Oberdach wieder in die Umgebung. Auf diese Weise umfliesst kühle Umgebungsluft praktisch den ganzen Innenraum 11 bzw. den diese abschliessenden Wandungen und führt überschüssige Wärme von diesen ab, ohne dass hierbei eine Vermischung der Umgebungsluft mit der Innenraumluft stattfindet. Es handelt sich hier also um eines der erwähnten geschlossenen Systeme, bei welchem die im Innenraum vorhandenen Komponenten mit Umgebungsluft nicht in Berührung kommen und optimal gegen Umwelteinflüsse wie Luftverschmutzung oder dergleichen geschützt sind.

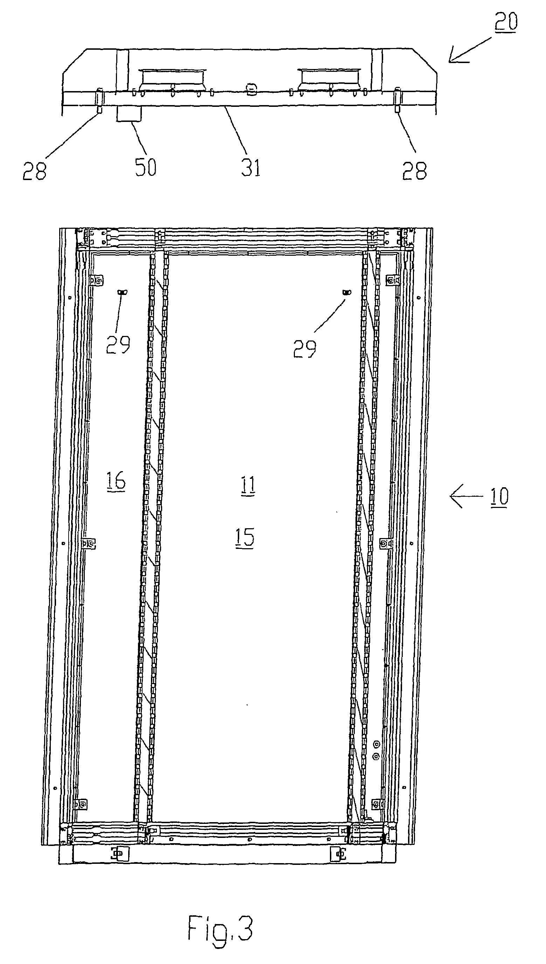

Wie in Fig. 2 und insbesondere in der Ausschnittsvergrösserung von Fig. 2a zu erkennen ist, ist das Dach 20 mit dem Schrankkörper 10 bzw. dessen Profilen 13 verschraubt, wobei an allen vier Ecken lediglich ein Schraubanschluss 28 mit je einer Mutter 29 vorgesehen ist. Wegen des erwähnten Abstandes der Racks 14 von den Seitenwänden 12 sind die Schraubanschlüsse 28 bzw. Muttern 29 von der Tür 12' aus auch dann noch zugänglich, wenn die Racks 14 mit Komponenten voll bestückt sind. Nach Lösen der Muttern 29 lässt sich das Dach 20 als Einheit komplett vom Schrankkörper 10 abheben, wie dies in Fig. 3 dargestellt ist. Bei abgehobenem Dach ist der Schrankkörper 10 nach oben offen.

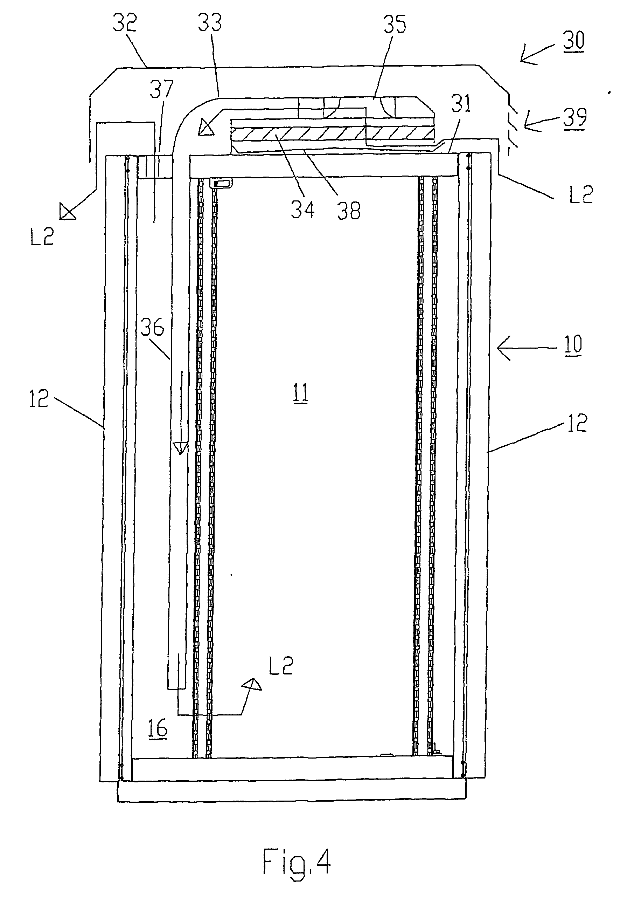

Fig. 4 zeigt in einer Darstellung gemäss Fig. 1, jedoch schematischer ausgeführt, eine Ausführungsform eines erfindungsgemässen Elektroschranks. Dieser weist den gleichen Schrankkörper 10 wie der von Fig. 1 auf, der hier jedoch mit einem Membranfilterdach 30 versehen ist.

Das Membranfilterdach 30 weist ein Unterdach 31 und ein Oberdach 32 auf. Das Unterdach 31 schliesst, wie das Unterdach 21 von Fig. 1, den Innenraum 11 des Schrankkörpers 10 nach oben ab. Das Oberdach 32 entspricht von seiner Form her insofern dem Oberdach 23 von Fig. 1, als dass es ebenfalls nach vorn und hinten hin über den Schrankkörper 10 etwas übersteht. Zusätzlich ist das Oberdach hier auch seitlich über den Schrankkörper jeweils überstehend dargestellt, was jedoch nicht bevorzugt ist, weil dann mehrere Elektroschränke nicht ohne Zwischenraum direkt nebeneinander aufgestellt werden könnten. Diese Art der Darstellung wurde lediglich gewählt, um den noch zu erläuternden Luftstrom L2 zeichnerisch besser darstellen zu können.

Zwischen dem Unterdach 31 und dem Oberdach 32 ist ein Gehäuse 33 angeordnet, welches ein Membranfilter 34 sowie einen Ventilator 35 aufnimmt. Das Membranfilter 34 ist liegend eingebaut, d.h. seine Dicke in vertikaler Richtung ist geringer als seine Ausdehnung in der Horizontalen. An das Gehäuse 33 angeschlossen ist weiter ein Kühlluftkanal 36. Dieser ist durch das Unterdach 31 in den Schrankkörper 10 hineingeführt und erstreckt sich im Bereich von dessen Aufnahmeraum 16 nach unten bis annähernd zu dessen Boden, wo er eine Öffnung aufweist. Mechanisch ist der Kühlluftkanal 36 ausschliesslich mit dem Membranfilterdach 30 verbunden und bildet ein integrales Teil desselben. Mit dem Schrankkörper 10 weist er keine mechanische Verbindung auf.

Der Ventilator 35 erzeugt einen kühlen Luftstrom L2 aus der Umgebung durch einen der Spalte zwischen Unter- und Oberdach (bevorzugt z.B. durch den vorderen Spalt) und das Membranfilter 34 in den Kühlluftkanal 36 hinein und durch diesen in den unteren Bereich des Schrankkörpers 10. Von dort steigt die Kühlluft im Schrankkörper unter Wärmeaufnahme auf, verlässt den Schrankkörper 10 nach oben durch Öffnungen 37 im Unterdach und tritt durch einen weiteren der Spalte (bevorzugt z.B. durch den hinteren Spalt) zwischen Unter- und Oberdach schliesslich wieder in die Umgebung aus. Es handelt sich hier also um eines der erwähnten offenen Systeme, bei welchem die im Innenraum vorhandenen Komponenten mit Umgebungsluft sehr wirksam direkt gekühlt werden. Durch das Membranfilter 34 wird die Umgebungsluft zuvor jedoch gefiltert, so dass zumindest die Staubbelastung der Komponenten gering gehalten werden kann. Bevorzugt erzeugt der Ventilator 35 mit der Kühlluft auch einen gewissen Überdruck im Innenraum, so dass Luft von aussen ausser über das Membranfilter 34 selbst durch allfällige Undichtigkeiten nicht eindringen kann. In diesem Fall brauchte man den Schrankkörper mit Vorteil nicht einmal hermetisch abzudichten.

Durch die beschriebene Führung der Kühlluft und indem diese das Membranfilter 34 von unten nach oben durchströmt, bleibt auch das Membranfilter 34 selbst zumindest von gröberem Schmutz weitestgehend unbelastet. Grössere und damit in der Regel auch schwerere Schmutzpartikel tendieren unter der Wirkung der Schwerkraft dazu, nach unten zu fallen und sich unterhalb des Membranfilters 34 zu sammeln. Zum Auffangen und bequemen Entfernen dieser Schmutzpartikel könnte auf dem Unterdach 31 eine flache Auffangwanne 38 zusätzlich vorgesehen sein, so wie dies in Fig 4 auch dargestellt ist. Die Auffangwanne 38 ist mit Vorteil auch noch mit einem hochgezogenen Rand versehen, der für den Kühlluftstrom L2 insbesondere zusammen mit dem erwähnten Lufteintrittsspalt eine Schikane bildet und dazu beträgt, Schmutzpartikel vom Membranfilter 34 fernzuhalten. Durch geeignete Ausbildung dieser Schikanen lässt sich zusätzlich in einfacher Weise ein Schutz gegen Spritzwasser erreichen. Zum Beispiel könnten anstellte des erwähnten einfachen Lufteintrittsspaltes eine Mehrzahl von schmalen, nach unten ausgerichteten Schlitzlamellen am bzw. im Oberdach vorgesehen sein, wie sie beispielhaft in Fig. 4 bei 39 dargestellt sind. Insgesamt trägt die beschriebene Ausbildung wesentlich dazu bei, dass das Membranfilter 34 über einen längeren Zeitraum durchgängig und damit funktionstüchtig bleibt und weniger oft ausgetauscht oder gereinigt werden muss.

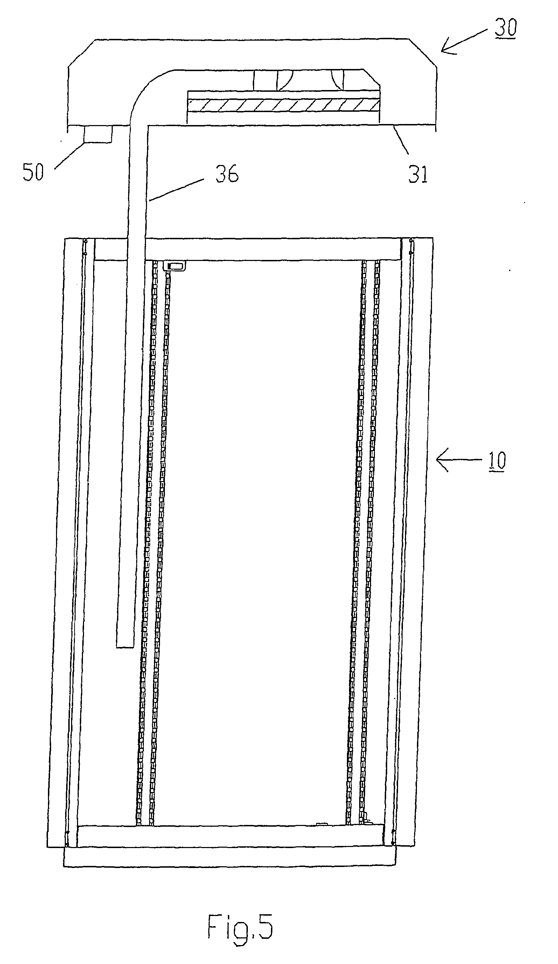

Das beschriebene Membranfilterdach 30 soll in gleicher Weise oder ähnlicher Weise wie das Kopflüfterdach 20 mit dem Schrankkörper 10 leicht lösbar verbunden und dadurch von diesem abnehmbar sein. Fig. 5 zeigt das Membranfilterdach 30 teilweise abgehoben von dem Schrankkörper 10. Indem der Kühlluftkanal 36 mit dem Gehäuse 33 sowie ggf. dem Unterdach 31, nicht jedoch mit dem Schrankkörper 10 verbunden ist, geht er beim Abnehmen des Daches 30 als Teil von diesem mit.

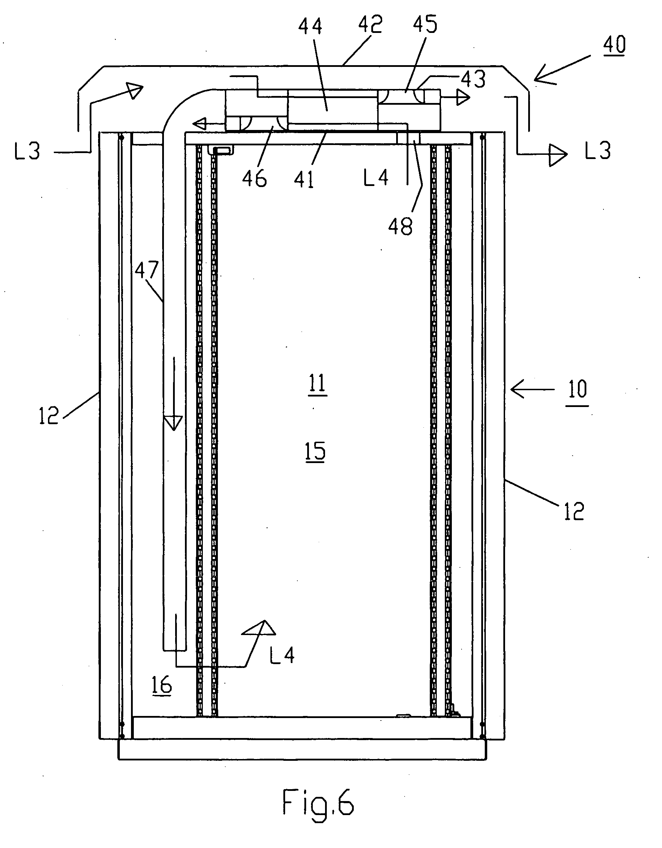

Fig. 6 zeigt in einer Darstellung gemäss Fig. 1, jedoch schematischer ausgeführt, eine weitere Ausführungsform eines erfindungsgemässen Elektroschranks. Dieser weist den gleichen Schrankkörper 10 wie der von Fig. 1 auf, der hier jedoch mit einem Wärmetauscherdach 40 versehen ist.

Das Wärmetauscherdach 40 weist ein Unterdach 41 und ein Oberdach 42 auf. Das Unterdach 41 schliesst, wie das Unterdach 21 von Fig. 1, den Innenraum 11 des Schrankkörpers 10 nach oben ab. Das Oberdach 42 entspricht von seiner Form her insofern dem Oberdach 23 von Fig. 1, als dass es ebenfalls nach vorn und hinten hin über den Schrankkörper 10 etwas übersteht. Zusätzlich ist das Oberdach hier auch seitlich über den Schrankkörper 10 jeweils überstehend dargestellt, was jedoch aus den bereits genannten Gründen wiederum nicht bevorzugt ist. Diese Art der Darstellung wurde lediglich gewählt, um den noch zu erläuternden Luftstrom L3 zeichnerisch besser darstellen zu können.

Zwischen dem Unterdach 41 und dem Oberdach 42 ist ein Wärmetauscheraggregat 43 angeordnet, welches einen als Röhrenwärmetauscher ausgebildeten Luft-Luft-Wärmetauscher 44 sowie zwei Ventilatoren 45 und 46 aufnimmt. An das Gehäuse 43 angeschlossen und dem Ventilator 46 nachgeordnet ist weiter ein Kühlluftkanal 47. Dieser ist durch das Unterdach 41 in den Schrankkörper 10 hineingeführt und erstreckt sich im Bereich von dessen Aufnahmeraum 16 nach unten bis annähernd zu dessen Boden, wo er eine Öffnung aufweist. Mechanisch ist der Kühlluftkanal 47 ausschliesslich mit dem Wärmetauscherdach 40 verbunden und bildet ein integrales Teil desselben. Mit dem Schrankkörper 10 weist er keine feste Verbindung auf.

Der Ventilator 45 erzeugt einen kühlen Luftstrom L3 aus der Umgebung durch einen ersten der Spalte zwischen Unter- und Oberdach (bevorzugt z.B. durch den vorderen Spalt) und den Wärmetauscher 44, wo er Wärme aus einem bevorzugt gegengerichteten Luftstrom L4 aufnimmt. Danach verlässt der Luftstrom L3 das Dach 40 wieder durch einen zweiten der Spalte zwischen Unter- und Oberdach (bevorzugt z.B. durch den hinteren Spalt) und tritt in die Umgebung aus. Der Luftstrom L4 wird durch den Ventilator 46 erzeugt und zirkuliert als geschlossener Kreislauf von diesem aus durch den Kühlluftkanal 47, den Innenraum 11 des Schrankkörpers 10 und den Röhrenwärmetauscher 44. Durch Öffnungen 48 im Unterdach 41 tritt er in das Gehäuse 44 ein. Es handelt sich hier also wieder um ein geschlossenes System, bei welchem die im Innenraum vorhandenen Komponenten mit Umgebungsluft nicht in Berührung kommen.

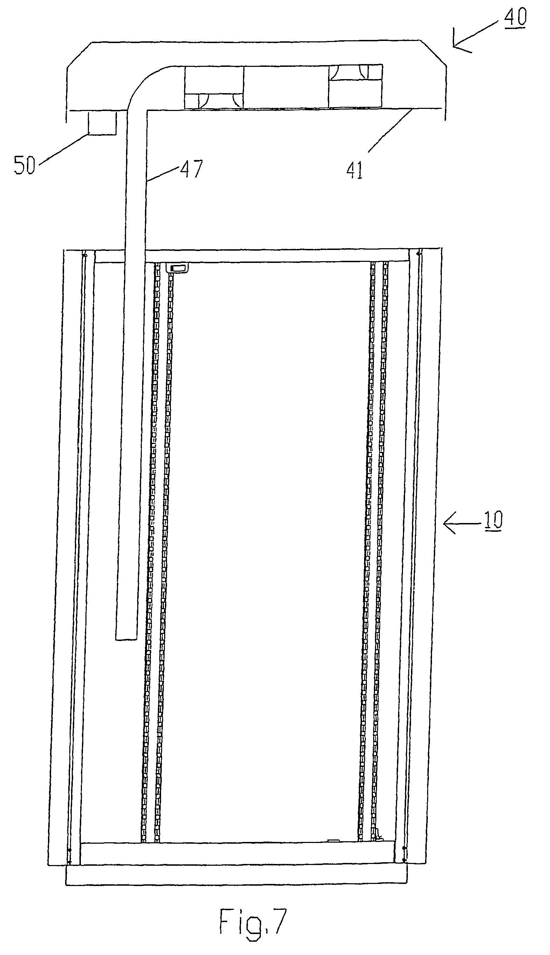

Das beschriebene Wärmetauscherdach 40 soll in gleicher Weise oder ähnlicher Weise wie das Kopflüfterdach 20 oder das Membranfilterdach 30 mit dem Schrankkörper 10 leicht lösbar verbunden und dadurch von diesem abnehmbar sein. Fig. 7 zeigt das Wärmetauscherdach 40 teilweise abgehoben von dem Schrankkörper 10. Indem der Kühlluftkanal 47 mit dem Gehäuse 43 sowie ggf. dem Unterdach verbunden ist, geht er beim Abnehmen des Daches 40 als Teil von diesem mit.

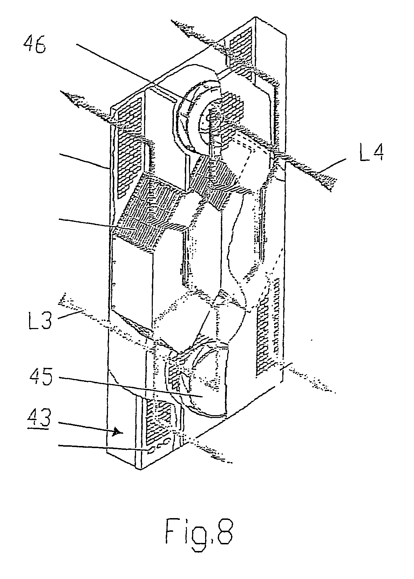

Fig. 8 zeigt noch eine schematische Darstellung eines Röhrenwärmetauschers, wie er von seinem Aufbau her für das Wärmetauscherdach 40 einsetzbar wäre. Eingezeichnet in Fig. 8 sind auch die Luftströme L3 und L4.

Es versteht sich, dass die beschriebenen Dächer 20, 30 und 40 von den Schrankkörpern 10 nicht nur abnehmbar, sondern im freien Austausch gegeneinander nach Art eines Baukastensystems auf diesen oder entsprechend ausgebildeten anderen Schrankkörpern 10 auch wieder montierbar sind. Weiter versteht sich, dass die drei beschrieben Dachvarianten natürlich nicht abschliessend zu verstehen sind und dass anderen Varianten ebenfalls möglich sind. Denkbar wäre z.B. auch eine Variante mit aktivem Kühlaggregat. Indem nach oben hin praktisch immer Platz vorhanden ist, können die unterschiedlichen Dachvarianten unterschiedliche Bauhöhen aufweisen. Die Ausbildung mit dem liegend im Dach eingebauten Membranfilter 34 und seine Anströmung von unten könnte auch ein eigenständiges, d.h. von der Auschtausidee etc. unabhängiges erfinderisches Konzept bilden.

Mit 50 ist schliesslich In den Fig. 3, 5 und 7 jeweils an der Unterseite des Unterdachs 21, 31 bzw. 41 noch eine Anschlussvorrichtung dargestellt, welche beispielsweise als Steckverbindung für elektrische Versorgungs- und/oder Signalleitungen ausgebildet sein kann. Über die Anschlussvorrichtung 50 kann z.B. ein im Innenraum 11 vorhandener Temperatursensor (nicht dargestellt) mit den im Dach 20, 30 oder 40 jeweils vorhandenen Entwärmungsaggregaten verbunden werden. Gleichfalls kann die Energierversorgung der im Dach enthaltenen Aggregate wie z.B. der beschriebenen Ventilatoren aus dem Innenraum heraus über diese Anschlussvorrichtung 50 erfolgen. Die Anschlussvorrichtung 50 ist selbstverständlich an einer Stelle angeordnet, an welcher sie wie die Anschlüsse 28 auch bei voller Bestückung des Innenraumes 11 noch gut erreichbar und zum Austausch eines Daches gut zu betätigen ist.

### BEZEICHNUNGSLISTE

- 10: Schrankkörper
- 11: Innenaum
- 12: doppelwandige Seitenwände
- 13: Profile
- 14: Racks
- 15: Aufnahmebereich für Komponenten
- 16: Aufnahmeraum für Kühlkanal
- 20: Kopflüfterdach
- 21: Unterdach
- 22: Zwischendach
- 23: Oberdach
- 24: erster Zwischenraum
- 25: zweiter Zwischenraum
- 26: dritter Zwischenraum zwischen dem Zwischendach und dem Oberdach randseitig
- 27: Ventilatoren
- 28: Anschlüsse
- 29: Muttern
- 30: Membranfilterdach
- 31: Unterdach
- 32: Oberdach
- 33: Gehäuse
- 34: Membranfilter
- 35: Ventilator
- 36: Kühlluftkanal
- 37: Öffnung im Unterdach 31
- 38: Auffangwanne
- 39: Schlitzlamellen
- 40: Wärmetauscherdach
- 41: Unterdach
- 42: Oberdach
- 43: Wärmetauscheraggregat
- 44: Röhrenwärmetauscher
- 45: Ventilator für Aussenkreislauf
- 46: Ventilator für Innenkreislauf
- 47: Kühlluftkanal
- 48: Öffnung im Unterdach 41
- 50: Anschlussvorrichtung für elektrische Versorgungs- und/oder Signalleitungen

## Patentansprüche

1. Elektroschrank für Verlustwärme erzeugende Komponenten mit einem Schrankkörper (10) und einem Dach (30), **dadurch gekennzeichnet,**
**dass** das Dach (30) mit lösbaren Anschlüssen (28) versehen und gegen ein mit entsprechenden Anschlüssen (28) versehenes Austauschdach austauschbar ist,
**dass** die Seitenwände (12) des Schrankkörpers einen Innenraum (11) umschliessen, in welchem weiterhin Racks (14) vorhanden sind,
**dass** der freie Raum zwischen den Racks (14) einen Aufnahmebereich (15) für die Komponenten bildet,
**dass** in dem Innenraum (11) neben dem Aufnahmebereich (15) für die Komponenten selbst bei voller Bestückung der Racks (14) mit Komponenten ein Aufnahmeraum (16) für einen Kühlluftkanal (36) vorhanden ist,
**dass** das Dach (30) ein Unterdach (31) und ein Oberdach (32) aufweist,
**dass** das Unterdach (31) den Innenraum (11) nach oben abschliesst,
**dass** zwischen dem Unterdach (31) und dem Oberdach (32) ein Gehäuse (33) angeordnet ist, welches einen Ventilator (35) aufnimmt,
**dass** an das Gehäuse (33) weiter ein Kühlluftkanal (36) angeschlossen ist,
**dass** der Kühlluftkanal (36) durch das Unterdach in den Innenraum (11) hineingeführt ist und sich in dessen Aufnahmeraum (16) nach unten bis annähernd zu dessen Boden erstreckt, wo er eine Öffnung aufweist, und
so dass der Ventilator (35) durch eine Luftansaugöffnung im Dach (unter anderem 39) Umgebungsluft ansaugt und über den Kühlluftkanal (36) als kühlen Luftstrom (L2) dem unteren Bereich des Innenraums (11) zuführt.

2. Elektroschrank nach Anspruch 1, **dadurch gekennzeichnet, dass** das Dach (30) mit einem Filter (34) versehen ist,
so dass der Ventilator (35) die Umgebungsluft durch das Filter (34) ansaugt.

3. Elektroschrank nach Anspruch 2, **dadurch gekennzeichnet, dass** das Filter von unten her angeströmt wird.

4. Elektroschrank nach einem der Asprüche 1 -3, **dadurch gekennzeichnet,**
**dass** das Unterdach (31) Öffnungen (37) gegen den Innenraum (11) aufweist,
so dass die Kühlluft von dem unteren Bereich des Innenraums (11) im Innenraum (11) unter Wärmeaufnahme aufsteigt, den Innenraum (11) nach oben durch diese Öffnungen (37) verlässt und danach aus dem Dach (30) wieder in die Umgebung austritt.

5. Elektroschrank für Verlustwärme erzeugende Komponenten mit einem Schrankkörper (10) und einem Dach (40), **dadurch gekennzeichnet,**
**dass** das Dach (40) mit lösbaren Anschlüssen (28) versehen und gegen ein mit entsprechenden Anschlüssen (28) versehenes Austauschdach austauschbar ist,
**dass** die Seitenwände (12) des Schrankkörpers (10) einen Innenraum (11) umschliessen, in welchem weiterhin Racks (14) vorhanden sind,
**dass** der freie Raum zwischen den Racks (14) einen Aufnahmebereich (15) für die Komponenten bildet,
und **dass** in dem Innenraum(11) neben dem Aufnahmebereich (15) für die Komponenten selbst bei voller Bestückung der Racks (14) mit Komponenten ein Aufnahmeraum (16) für einen Kühlluftkanal (47) vorhanden ist,
**dass** das Dach (40) ein Unterdach (41) und ein Oberdach (42) aufweist,
**dass** das Unterdach (41) den Innenraum (11) nach oben abschliesst,
**dass** zwischen dem Unterdach (41) und dem Oberdach (42) ein Wärmetauscheraggregat (43) angeordnet ist, welches einen Luft-Luft Wärmetauscher (44) sowie einen ersten (45) und einen zweiten Ventilator (46) aufnimmt,
**dass** an das Wärmetauscheraggregat (43) weiter ein Kühlluftkanal (47) angeschlossen und dem zweiten Ventilator (46) nachgeordnet ist,
**dass** der Kühlluftkanal (47) durch das Unterdach (41) in den Innenraum (11) hineingeführt ist und sich in dessen Aufnahmeraum (16) nach unten bis annähernd zu dessen Boden erstreckt, wo er eine Öffnung aufweist,
so dass der erste Ventilator (45) einen ersten kühlen Luftstrom (L3) aus der Umgebung durch den Wärmetauscher (44) erzeugt, wo er Wärme aus einem zweiten Luftstrom (L4) aufnimmt,
so dass danach der erste Luftstrom (L3) das Dach (40) verlässt und wieder in die Umgebung austritt,
so dass der zweite Luftstrom (L4) durch den zweiten Ventilator (46) erzeugt wird und als geschlossener Kreislauf von diesem aus durch den Kühlluftkanal (47), den Innenraum (11) und den Luft-Luft-Wärmetauscher (44) zirkuliert und
so dass er durch Öffnungen (48) im Unterdach (41) in das Wärmetauscheraggregat (43) eintritt.

6. Elektroschrank nach Anspruch 5, **dadurch gekennzeichnet, dass** der Luft-Luft Wärmetauscher (44) als Röhrenwärmetauscher ausgebildet ist.

7. Elektroschrank nach Anspruch 1 - 6, **dadurch gekennzeichnet, dass** die lösbaren Anschlüsse (28) des Dachs (30; 40) auch dann vom Innenraum (11) her noch zugänglich sind, wenn dieser mit Komponenten voll bestückt ist.

8. Elektroschrank nach einem der Ansprüche 1 - 7, **dadurch gekennzeichnet, dass** der Kühlluftkanal (36; 47) eine Breite von etwa 50 oder 100 mm und eine Tiefe von etwa 300 mm aufweist.

9. Elektroschrank nach einem der Ansprüche 1 - 8, **dadurch gekennzeichnet, dass** der Kühlluftkanal (36; 47) ausschliesslich mit dem Dach (30; 40) verbunden ist und durch dieses gehalten wird.

10. Elektroschrank nach einem der Ansprüche 1 - 9, **dadurch gekennzeichnet, dass** das Dach (30; 40) als Ganzes handhabbar ist.

11. Elektroschrank nach einem der Ansprüche 1 - 10, **dadurch gekennzeichnet, dass** das Dach (30; 40) gegen den Innenraum (11) hin mit einer Anschlussvorrichtung (50) für elektrische Versorgungs- und/oder Signalleitungen versehen ist.

12. Elektroschrank nach einem der Ansprüche 1 - 11, **dadurch gekennzeichnet, dass** die Seitenwände (12) des Schrankkörpers doppelschalig ausgebildet sind und dass der Zwischenraum zwischen den Schalen der Seitenwände (12) nach unten zur Umgebung hin offen ist.

## Claims

1. Electrical equipment cabinet for components generating dissipated heat with a cabinet body (10) and a roof (30), **characterised**
**in that** the roof (30) is equipped with detachable connectors (28) and is exchangeable for an exchange roof fitted with corresponding connectors (28),
**in that** the sidewalls (12) of the cabinet body enclose an interior space (11) in which racks (14) are additionally present,
**in that** the free space between the racks (14) forms an accommodation area (15) for the components,
**in that** there is present in the interior space (11), in addition to the accommodation area (15) for the components themselves, an accommodation space (16) for a cooling air duct (36) even when the racks (14) are fully loaded with components,
**in that** the roof (30) has a lower roof (31) and an upper roof (32),
**in that** the lower roof (31) closes off the interior space (11) at the top,
**in that** between the lower roof (31) and the upper roof (32) there is arranged a housing (33) that accommodates a blower (35),
**in that** furthermore a cooling air duct (36) is attached to the housing (33),
**in that** the cooling air duct (36) is passed through the lower roof into the interior space (11) and extends in the latter's accommodation space (16) downwards as far as almost to its base, where it has an opening, and
in such a way that the blower (35) sucks in ambient air through an air intake opening in the roof (inter alia 39) and feeds it through the cooling air duct (36) as a cool air stream (L2) to the lower region of the interior space (11).

2. Electrical equipment cabinet according to Claim 1, **characterised in that** the roof (30) is equipped with a filter (34)
so that the blower (35) sucks in the ambient air through the filter (34).

3. Electrical equipment cabinet according to Claim 2, **characterised in that** the flow approaches the filter from below.

4. Electrical equipment cabinet according to one of the Claims 1 - 3, **characterised in that** the lower roof (31) has openings (37) to the interior space (11),
so that the cooling air rises up in the interior space (11) from the lower region of the interior space (11) absorbing heat as it does so, leaves the interior space (11) at the top through these openings (37) and thereafter exits out of the roof (30) and re-enters the surroundings.

5. Electrical equipment cabinet for components generating dissipated heat with a cabinet body (10) and a roof (40), **characterised**
**in that** the roof (40) is equipped with detachable connectors (28) and is exchangeable for an exchange roof fitted with corresponding connectors (28),
**in that** the sidewalls (12) of the cabinet body (10) enclose an interior space (11) in which racks (14) are additionally present,
**in that** the free space between the racks (14) forms an accommodation area (15) for the components,
**in that** there is present in the interior space (11), in addition to the accommodation area (15) for the components themselves, an accommodation space (16) for a cooling air duct (47) even when the racks (14) are fully loaded with components,
**in that** the roof (40) has a lower roof (41) and an upper roof (42),
**in that** the lower roof (41) closes off the interior space (11) at the top,
**in that** between the lower roof (41) and the upper roof (42) there is arranged a heat exchanger assembly (43) that accommodates an air-air heat exchanger (44) together with a first (45) and a second blower (46),
**in that** furthermore a cooling air duct (47) is attached to the heat exchanger assembly (43) and is arranged downstream of the second blower (46),
**in that** the cooling air duct (47) is passed through the lower roof (41) into the interior space (11) and extends in the latter's accommodation space (16) downwards as far as almost to its base, where it has an opening,
in such a way that the first blower (45) sucks in a first cool air stream (L3) from the surroundings through the heat exchanger (44) where it absorbs heat from a second air stream (L4),
so that thereafter the first air stream (L3) leaves the roof (40) and re-enters the surroundings,
so that the second air stream (L4) is generated by the second blower (46) and circulates as a closed circulation out of the latter, through the cooling air duct (47), the interior space (11) and the air-air heat exchanger (44), and
so that it enters into the heat exchanger assembly (43) through openings (48) in the lower roof (41).

6. Electrical equipment cabinet according to Claim 5, **characterised in that** the air-air heat exchanger (44) is constructed as a tube heat exchanger.

7. Electrical equipment cabinet according to Claim 1 - 6, **characterised in that** the detachable connectors (28) of the roof (30; 40) are still accessible from the interior space (11) even when the latter is fully loaded with components.

8. Electrical equipment cabinet according to one of the Claims 1 - 7, **characterised in that** the cooling air duct (36; 47) has a width of about 50 or 100 mm and a depth of about 300 mm.

9. Electrical equipment cabinet according to one of the Claims 1 - 8, **characterised in that** the cooling air duct (36; 47) is connected exclusively to the roof (30; 40) and is supported by this.

10. Electrical equipment cabinet according to one of the Claims 1 - 9, **characterised in that** the roof (30; 40) can be handled as a whole.

11. Electrical equipment cabinet according to one of the Claims 1 - 10, **characterised in that** the roof (30; 40) is equipped facing the interior space (11) with a connection device (50) for electrical supply and/or signal cables.

12. Electrical equipment cabinet according to one of the Claims 1 - 11, **characterised in that** the sidewalls (12) of the cabinet body are of double-shell construction and **in that** the intermediate space between the shells of the sidewalls (12) is open to the surroundings at the bottom.

## Revendications

1. Armoire électrique pour composants produisant une dissipation de chaleur avec un corps d'armoire (10) et un toit (30), **caractérisée :**
- **en ce que** le toit (30) est muni de liaisons (28) amovibles et peut être remplacé par un toit de rechange muni de liaisons correspondantes ;
- **en ce que** les parois latérales (12) du corps d'armoire enserrent un espace intérieur (11) dans lequel se trouvent des racks (14) à garnir ;
- **en ce que** l'espace libre entre les racks (14) forme une zone d'accueil des composants ;
- **en ce que** un espace d'accueil (16) pour un canal d'air de refroidissement (36) est ménagé dans l'espace intérieur (11) à côté de la zone d'accueil (15) des composants même lorsque les racks (14) sont complètement garnis de composants ;
- **en ce que** le toit (30) présente un toit inférieur (31) et un toit supérieur (32)
- **en ce que** le toit inférieur (31) ferme l'espace intérieur (11) vers le haut ;
- **en ce que** entre le toit inférieur (31) et le toit supérieur (32) est disposé un boîtier (33) qui accueille un ventilateur (35) ;
- **en ce que** le logement (33) est en outre connecté à un canal d'air de refroidissement (36) ;
- **en ce que** le canal d'air de refroidissement (36) est inséré à travers le toit inférieur jusque dans l'espace intérieur (11) et s'étend vers le bas dans l'espace d'accueil (16) approximativement jusqu'au plancher, où il présente une ouverture ;
- de façon à ce que le ventilateur (35) aspire l'air ambiant à travers à travers une ouverture d'aération (39 parmi d'autres) dans le toit et le fasse circuler par le canal d'air de refroidissement (36) en tant que flux d'air de refroidissement (L2) vers la région inférieure de l'espace intérieur (11).

2. Armoire électrique selon la revendication 1, **caractérisée en ce que** le toit (30) est muni d'un filtre (34),
de façon à ce que le ventilateur (35) aspire l'air ambiant à travers ledit filtre (34).

3. Armoire électrique selon la revendication 2, **caractérisée en ce que** le filtre reçoit l'air par le bas.

4. Armoire électrique selon l'une quelconque des revendications 1 à 3, **caractérisée en ce que** le toit inférieur (31) présente des ouvertures (37) donnant sur l'espace intérieur (11),
de façon à ce que l'air de refroidissement s'élève sous l'effet de son réchauffement dans de l'espace intérieur (11) depuis sa partie inférieure, quitte l'espace intérieur (11) à travers ces ouvertures (37) puis s'échappe du toit (30) jusque dans l'environnement extérieur.

5. Armoire électrique pour composants produisant une dissipation de chaleur avec un corps d'armoire (10) et un toit (40), **caractérisée :**
- **en ce que** le toit (40) est muni de liaisons (28) amovibles et peut être remplacé par un toit de rechange muni de liaisons correspondantes (28) ;
- **en ce que** les parois latérales (12) du corps d'armoire (10) enserrent un espace intérieur (11) dans lequel se trouvent des racks (14) à garnir ;
- **en ce que** l'espace libre entre les racks (14) forme une zone d'accueil des composants ;
- **en ce que** un espace d'accueil (16) pour un canal d'air de refroidissement (37) est ménagé dans l'espace intérieur (11) à côté de la zone d'accueil (15) des composants même lorsque les racks (14) sont complètement garnis de composants ;
- **en ce que** le toit (40) présente un toit inférieur (41) et un toit supérieur (42)
- **en ce que** le toit inférieur (41) ferme l'espace intérieur (11) vers le haut ;
- **en ce qu'**entre le toit inférieur (41) et le toit supérieur (42) est disposé un groupe d'échange de chaleur (43), lequel reçoit un échangeur de chaleur air-air (44) ainsi qu'un premier (45) et un deuxième (46) ventilateur ;
- **en ce qu'**un canal d'air de refroidissement (47) est en outre raccordé au groupe d'échange de chaleur (43) et disposé à la suite du deuxième ventilateur (46) ;
- **en ce que** le canal d'air de refroidissement (47) est inséré à travers le toit inférieur (41) jusque dans l'espace intérieur (11) et s'étend vers le bas dans l'espace d'accueil (16) approximativement jusqu'au plancher, où il présente une ouverture ;
- de façon à ce que le premier ventilateur (45) produise un premier flux d'air frais (L3) provenant de l'environnement extérieur à travers l'échangeur de chaleur (44), où il reçoit de la chaleur de la part d'un deuxième flux d'air (L4) ;
- de façon à ce qu'alors le premier flux d'air (L3) s'échappe du toit (40) jusque dans l'environnement extérieur ;
- de façon à ce que le deuxième flux d'air (L4) se produise à travers le deuxième ventilateur (46) et circule en circuit fermé en sortant de celui-ci et à travers le canal d'air de refroidissement (47) et l'échangeur de chaleur air-air (44) ;
- de façon à ce qu'il pénètre dans le groupe d'échange de chaleur (43) à travers des ouvertures (48) dans le toit inférieur.

6. Armoire électrique selon la revendication 5, **caractérisée en ce que** l'échangeur de chaleur air-air est formé d'un échangeur de chaleur à tubes.

7. Armoire électrique selon l'une quelconque des revendications 1 à 6, **caractérisée en ce que** les liaisons amovibles (28) du toit (30, 40) sont encore accessibles lorsque celle-ci est entièrement garnie de composants.

8. Armoire électrique selon l'une quelconque des revendications 1 à 7, **caractérisée en ce que** le canal d'air de refroidissement (36, 47) présente une largeur d'environ 50 ou 100 mm et une profondeur d'environ 300 mm.

9. Armoire électrique selon l'une quelconque des revendications 1 à 8, **caractérisée en ce que** le canal d'air de refroidissement (36, 47) est exclusivement relié au toit (30, 40) et est maintenu par celui-ci.

10. Armoire électrique selon l'une quelconque des revendications 1 à 9, **caractérisée en ce que** le toit (30, 40) est démontable à la main et d'un seul morceau.

11. Armoire électrique selon l'une quelconque des revendications 1 à 10, **caractérisée en ce que** le toit (30, 40) est muni d'un dispositif de raccordement (50) donnant sur l'espace intérieur (11) pour des alimentations électriques et/ou des conducteurs de signal.

12. Armoire électrique selon l'une quelconque des revendications 1 à 11, **caractérisée en ce que** les parois latérales (2) du corps d'armoire sont construites en double épaisseur et que l'espace entre les épaisseurs des parois latérales (12) s'ouvre par le bas sur l'atmosphère extérieure.
